# EUROPEAN PATENT APPLICATION

(11) **EP 0 632 380 A1**
(43) Date of publication of application: **04.01.1995**
(21) Application number: 93480082.2
(22) Date of filing: 30.06.1993
(51) Int. Cl.: G06F 11/20

(54) **A circuit allowing a two-pass fuse blow to memory chips combining abist and redundancy capabilities**

(71) Applicant: International Business Machines Corporation, Armonk, N.Y. 10504 (US)
(72) Inventor: Mifsud, Jean-Paul, F-77127 Lieusaint (FR); Rapoport, Stuart, Washington DC 20016 (US)
(74) Representative: Klein, Daniel Jacques Henri

(57) **Abstract**

There is described a novel circuit that identifies the defective redundant word lines in the memory unit of a state of the art SRAM macro including an ABIST structure and a redundancy mechanism. The novel circuit (41) combines existing signals: the selection signals R1 to Rq, the RESULT and the COMPOSITE RESULT signals that are generated as standard in such macros. The selection signals R1 to Rq indicate whether or not a redundant word line has been selected. The RESULT signal indicates whether or not the memory unit at the address being tested is defective after a READ operation. The COMPOSITE RESULT signal indicates that the number of fails detected exceeds the number q of redundant word lines. All these signals run on a cycle per cycle basis. According to the invention, the selection signals R1 to Rq are applied to a q-way OR gate (42) whose output is connected to a latch (43). The signal which is output by the latch and the RESULT signal are ANDed in a 2-way AND gate (44). The signal (RLBU**) which is generated by the AND gate (44) indicates whether or not the redundant word line that was used is defective. In a preferred embodiment, this signal (RLBU**), and the COMPOSITE RESULT signal are applied as inputs to a 3-way OR gate (26'), whose output is connected to a self-maintained latch (27), referred to as the "not fixable" latch. The third input of said 3-way OR gate is connected to the "not fixable" latch output. If there is a fail on a redundant word line, the "not fixable" latch is set to indicate a non repairable state of the SRAM macro memory unit. As a result, a two-pass fuse blow process is now made possible, which significantly increases the manufacturing yields and repairability of said SRAM macro.

## Description

The present invention relates to the test of integrated circuits of the memory type, such as stand-alone SRAMs or logic arrays with embedded SRAM macros provided with built-in self-test and redundancy capabilities, fabricated in semiconductor chips. It more particularly relates to a novel circuit that identifies the defective word lines of the memory unit redundant array. As a result, a second pass of fuse blow after the burn-in step is thus allowed, thus significantly improving the repairability of said integrated circuits.

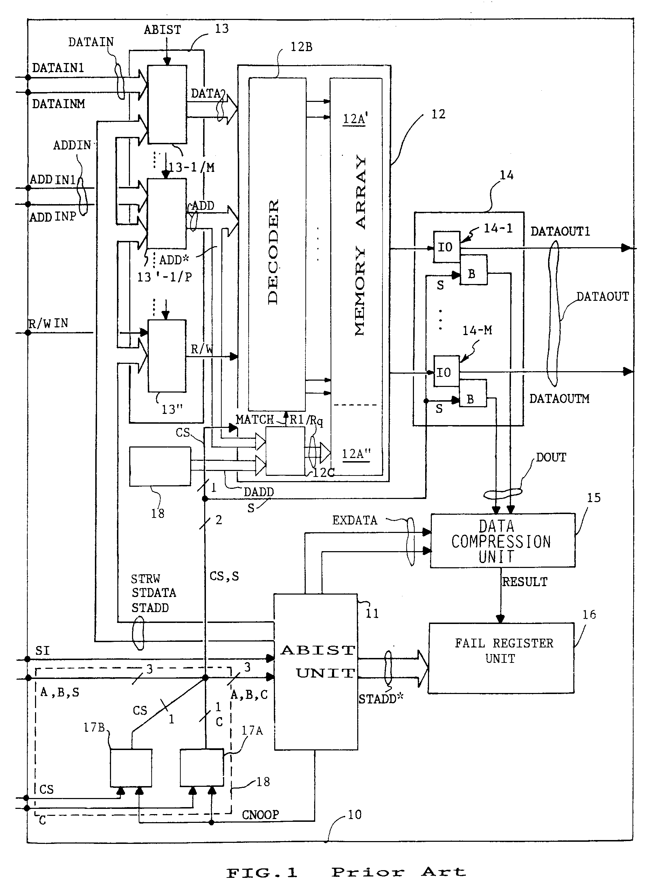

As memories get faster, more complex, and denser, there is an increasing demand on ABIST (Array Built-In Self-Test) structures for logic and memory fault detection offering high speed and high test coverage, while consuming minimal area on the semiconductor chip. In addition, it is also highly desired to have a redundancy mechanism (word or bit line) to be combined therewith for repairability purposes. The combination of these two features will become more prevalent in a close future in the manufacturing of large memories due to a number of reasons including testing cost/time and yield improvement. For example, to date, in conventional SRAM macros implementing this combined feature, the replacement of defective lines by redundant lines is performed on product chips at the wafer level before the burn-in step and is limited to a single pass of fuse blow, as it will be now explained in conjunction with Figs. 1 to 3.

For sake of illustration, Fig. 1 shows the block diagram architecture of a state of the art SRAM macro 10 provided with an ABIST unit 11. A similar architecture is described in Ref. D1: US-A-5 173 906 assigned to the assignee of the present invention. The functional units shown in Fig. 1, either form a part of a stand-alone SRAM or the SRAM macro of a logic array of an integrated circuit chip. In the latter case, the chip may include a plurality of such macros, each being provided with its own dedicated ABIST unit. The said integrated circuit chip is part of a wafer fabricated in a very large scale integration (VLSI) semiconductor technology and is designed according to level-sensitive scan design (LSSD) rules.

As known for those ordinary skilled in the art, the SRAM macro 10 of Fig. 1 has three basic operating modes. The first one is the SYSTEM mode, according to which the SRAM macro 10 is in normal operation, i.e. where the memory unit 12 is either read or written, using the data-in signals DATAIN1 to DATAINM, the SRAM address signals ADDIN1 to ADDINP, and the read/write control signal R/WIN (wherein M and P are the respective bit widths of the data-in bus DATAIN and the SRAM address bus ADDIN). The second mode is required because of the LSSD construction: the SCAN mode which is used for initializing/analyzing (SCAN-IN/SCAN-OUT) all the data of the latch pairs, which are used extensively in the SRAM macro architecture of Fig. 1, to form the LSSD chain. Finally, the third mode is the ABIST mode, in which the memory unit 12 functionality is tested. It is a self-test which is first performed in the manufacturing environment, before the chip is commercially released. A slightly different, more relaxed self-test is performed while the chip is incorporated in a system, for example at the customer location, and thus in the system environment. As a result, the ABIST mode is used in different environments referred to hereinbelow as the ABIST mfg sub-mode and the ABIST system sub-mode.

In the ABIST mode, according to the fundamentals of the self-test technique, the ABIST unit 11 generates a plurality of test pattern sequences. Each test pattern consists of a set of deterministic one's and zero's that are first written into the memory unit 12, then read out and compared with the expected pattern. Said test pattern sequences have thus the key role of exercising the memory unit 12 in order to verify, with a given precision, whether or not the memory unit 12 under test is properly functioning, i.e. to determine whether the READ and WRITE operations have been successful or not. To that end, the ABIST unit 11 generates self-test data signals STDATA, self-test address signals STADD, and the self-test read/write control signal STRW.

Three groups of multiplexers have the role of selecting the signals to be fed in the memory unit 12, i.e. either the external signals mentioned above coming from outside the SRAM macro 10, i.e. the DATAIN1 to DATAINM, ADDIN1 to ADDINP, and R/WIN signals, or the internal self-test signals generated by the ABIST unit 11 mentioned above i.e. the STDATA, STADD, and STRW signals. In Fig. 1, the multiplexers forming these three groups are respectively referenced 13-1 to 13-M, 13'-1 to 13'-P, and 13''. The selection is made under the control of the ABIST control signal. Usually, when the ABIST signal is held at the logic "0", the external signals are selected and when held at the logic "1", the signals that are internally generated by the ABIST unit 11 are selected. The ABIST signal thus allows the SRAM macro 10 to operate either in the SYSTEM mode or in the ABIST mode. The said three groups of multiplexers, i.e. 13-1 to 13-M, 13'-1 to 13'-P, and 13'' form multiplexer block 13. The outputs of the first and second groups are labelled DATA bus and ADD bus, with M and P respective bit widths. The output of multiplexer 13'' is a single wire which transports the R/W control signal which determines the READ/WRITE operating mode of memory unit 12.

The data-out signals that are output by the memory unit 12 are stored in a battery of data-out L1/L2 latch pairs referenced 14-1 to 14-M forming the data-out shift register unit 14. Generally, these data-out latch pairs are incorporated in the memory unit 12. The data-out signals that are output by the L1 and L2 latches are labelled DATAOUT1 to DATAOUTM (DATAOUT bus) and DOUT1 to DOUTM (DOUT bus) respectively. In the ABIST mode, after a READ operation has been performed, expected data signals labelled EXDATA are generated by the ABIST unit 11 on the EXDATA bus and compared in the data compression unit 15 with the data-out signals DOUT1 to DOUTM. Typically, only four test patterns are used on each word of the memory unit 12: alternate zero's and one's, i.e. 0101...01 and 1010...10), all zero's and all one's. In others words, there are only four self-test data signals, labelled STDATA0, STDATA1 and their respective complements. Because of the particular structure of these four test patterns, the data-out signals DOUT1 to DOUTM are divided into even and odd data-out signals. The even data-out signals that are output from the data-out shift register unit 14 are labelled DOUT2, DOUT4,..., DOUT2j, and similarly, the odd data-out signals are labelled DOUT1, DOUT3,..., DOUT(2j-1), where j is an integer equal to M/2, assuming M is an even number. Therefore, as all the even and odd numbered bits of the data-out signals are at the same '0' or '1' value at the same time, only two expected data signals, each one consisting of a single bit, labelled EXDATA0 and EXDATA1 are required. For instance, assuming the data-out signals to be read on the DOUT bus are: 010101...01, the expected data signal EXDATA0 (for the even numbered bits) will be "1" and the expected data signal EXDATA1 (for the odd numbered bits) will be "0". Said EXDATA0 and EXDATA1 signals are thus the expected results for the even and odd data-out signals respectively. Finally, data compression unit 15 generates a signal labelled RESULT which is held at a high logic level, i.e. the "1" logic state, if there is a mismatch during the comparison. By mismatch, it is meant that at least one data-out signal does not have the same logic value as its corresponding even or odd expected data generated by the ABIST structure 11. This mismatch is often caused by a defective word line in the memory unit 12 at a determined address. This mismatch is usually referred to as a "fail". On the contrary, if all data-out signals match with the corresponding even or odd expected data signals (which means no fail is detected), then the RESULT signal is held at the low logic level, i.e. the "0" logic state. The RESULT signal, which is often referred to in the literature as the FAIL FOUND LAST CYCLE signal, indicates after a READ operation, whether the memory unit 12 at the current address being tested, is defective or not. The RESULT signal is therefore indicative of the fail/no fail status of memory unit 12, on a cycle by cycle basis. Another key component of the state of the art SRAM macro 10 is the fail register unit 16. It is required because, in the ABIST mfg sub-mode, the addresses of the defective word lines have to be identified, then memorized for subsequent use in the SYSTEM mode. When the RESULT signal is raised to a logic "1", indicating thereby existence of a fail, the word portion of the current address generated by the ABIST unit 11 on the STADD bus, labelled STADD*, is stored in a bank of latch pairs of this fail address register unit 16. This stored word address thus corresponds to the address of a defective word line.

The ABIST unit 11 also generates a CNOOP (NOOP stands for NO OPERATION) signal to inhibit the ABIST self-test mode, when the totality of the test pattern sequences has been fully exercised on the memory unit 12. This signal is absolutely required when there is a plurality of SRAM macros embedded in a single semiconductor chip. Said macros may have different sizes thus requiring different durations for their respective test. The CNOOP signal generated by the ABIST unit of each SRAM macro allows the memory units of all macros to be simultaneously tested.

The general clocking of SRAM macro 10 is achieved as standard in accordance with LSSD rules. In the state of the art architecture of the SRAM macro 10 illustrated in Fig. 1, the clocking would be normally implemented by standard external LSSD clock signals labelled A, B, C, and S, and by the CS (CHIP SELECT for a stand-alone SRAM chip or ARRAY SELECT for a SRAM macro) signal. Note that the S clock signal, which is substantially the same as the B clock signal, is applied to the L2 latches of latch pairs 14-1 to 14-M of data-out shift register unit 14. In the ABIST mfg sub-mode, the clock and CS signals are derived from the tester. In the ABIST system sub-mode, these signals are derived from the system clock. The SCAN-IN (SI) signal is applied to the ABIST unit 11 according to the standard LSSD rules, as illustrated in Fig. 1. However, for sake of simplicity, the SCAN-OUT signal generated by the ABIST unit 11 in response to the SCAN-IN signal, to be applied as the SCAN-IN signal to the next latch pair, and so on, along the whole LSSD chain, has not been represented. In the following description, only latches will be mentioned while it is clear, that according to the LSSD concept, they are latch pairs in reality. All these signals are directly applied to the ABIST unit 11 and/or the memory unit 12, except the C clock and CS signals. The C clock signal is applied to one input of 2-way AND gate 17A. The CS signal is applied to one input of 2-way AND gate 17B. The CNOOP signal is applied to the other input of these AND gates 17A and 17B as a gating signal, in order to block, when needed, the transmission of the respective C clock and CS signal. This occurs when the self-test has been completed in the ABIST mode, and permanently in the SYSTEM mode. The A, B, and S clock signals are used during the SCAN mode, and the B, C, S and CS signals are used during the ABIST mode. The CS signal is used alone in the SYSTEM mode, and the LSSD clock signals are held in a non-active state. Numeral 18 schematically illustrates the clock distribution scheme in the SRAM macro 10 and also includes the internal chip clock distribution network servicing it. This terminates the description of a state of the art SRAM macro provided with an ABIST structure.

Let us now briefly describes how a typical word line redundancy mechanism can be implemented in the state of the art SRAM macro architecture of Fig. 1. Note that a bit line or a block redundancy mechanism could be implemented as well. Now still referring to Fig. 1 and for sake of illustration, it is convenient to consider that the memory unit 12 is comprised of three blocks: the memory cell array 12A, the word and bit line decoder 12B and a comparator 12C. Memory cell array 12A is subdivided in two parts: the regular array 12A' and the redundant array 12A''. Let us assume that the redundant array 12A'' contains q redundant word lines. The SRAM macro 10 further includes a storage unit 19 that contains non volatile programmable elements, such as metal or polycristalline fuses, which store the addresses of the defective word lines of the regular array 12A' to be replaced by redundant word lines, referred to hereafter as the defective word addresses. As apparent from Fig. 1, all the connections between these elements are standard.

Compare circuit 12C receives a first bus, referred to as the ADD* bus, which transports the word portion of the address available on the ADD bus and a second bus which contains all the defective word line addresses, referred to as the DADD bus, from said storage unit 19. In addition to said defective word line addresses, the DADD bus also includes q "flag" wires. Each "flag" wire transports a signal that indicates whether a defective word line is active or not. As well known for those skilled in the art, the base of the redundancy mechanism is a comparison function made to reroute addressing of defective word lines of the regular array 12A' towards redundant word lines of the redundant array 12A''. At each cyle, the current address is applied to the decoder 12B and in parallel, the word portion thereof, on bus ADD*, is compared with the defective word addresses stored in storage unit 19, in comparator 12C. This comparison aims to determine whether the current word address corresponds to the address of a defective word line or not. If found defective, the word line of the regular array 12A' has to be replaced by one of the q redundant word lines of the redundant array 12A''. This selection is achieved by comparator 12C which activates the appropriate one of the selection signals R1 to Rq. Selection signals R1 to Rq are transported on the R1/Rq bus, from comparator 12C to the redundant array 12A''. In addition, a control signal labelled MATCH is also sent to the decoder block 12B to inhibit the latter if there is a match between the current address present on the ADD* bus and one of the addresses present on the DADD bus. The MATCH signal which controls only the final stage of the word and bit line decoder 12B, inhibits only the word portion thereof.

Another key component of the redundancy mechanism is the fail register unit 16. In the ABIST mfg sub-mode, the addresses of the defective word lines once identified, are temporarily stored in said fail address register 16, then permanently memorized in storage unit 19. These stored defective word addresses will be subsequently and permanently used in the SYSTEM mode. Obviously, there is a 1 to 1 correspondence between the addresses stored in the storage unit 19 and in the fail address register unit 16.

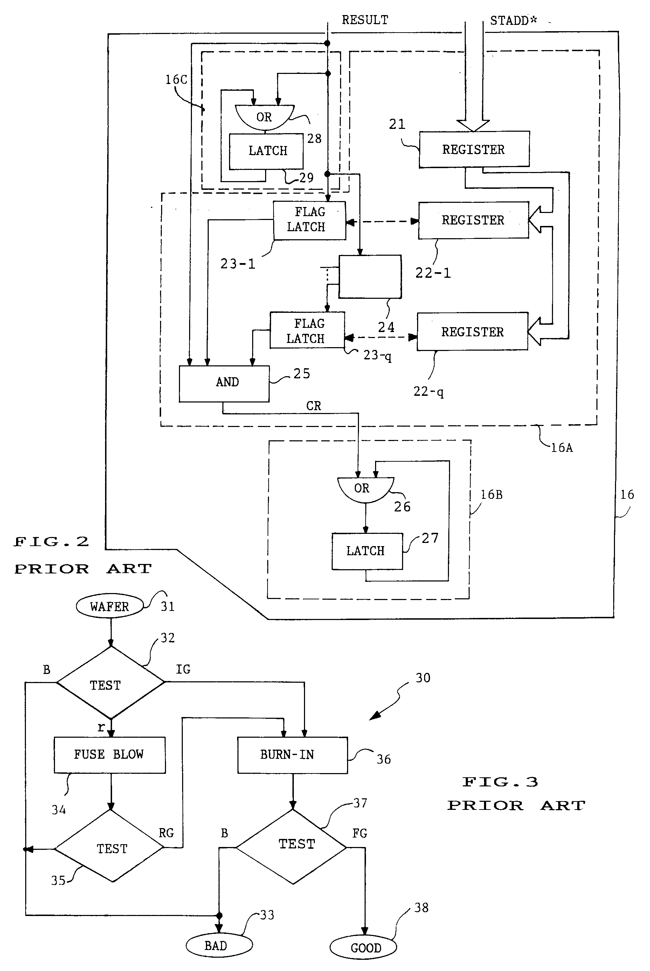

The storage process will be explained in more details in conjunction with Fig. 2, which schematically illustrates the circuit implementation of a conventional fail address register unit 16, such as described in Refs. D1 and D2. It is comprised of two essential blocks 16A and 16B and a third block 16C which could be optionally located in the data compression unit 15 as well. Block 16A includes address load register 21 which receives the STADD* signal bus, i.e. the word portion of the self-test addresses, from the ABIST unit 11. The output bus of register 21 is connected in parallel to the input of q fail address registers 22-1 to 22-q. Note that a number of fail address registers different from the number q of redundant word lines could be envisioned as well. The role of fail address register 22-1 is to store the first defective (failing) word address, and so on, until fail address register 22-q which stores the qth defective word address. To each of these fail address registers is associated a corresponding "flag" latch referenced 23-1 to 23-q. The RESULT signal generated by the data compression unit 15 is applied to the input of "flag" latch 23-1, to the input of an enabler logic 24, and to one input of (q+1)-way AND gate 25. The role of enabler logic 24, which essentially consists of AND gates, is to store an appropriate logic value in the "flag" latches 23-2 to 23-q, so that, any time this logic value is stored in a determined "flag" latch, its corresponding fail address register is inhibited, i.e. it is prevented from receiving a new defective word address. This reasoning applies to "flag" latch 23-1 and register 22-1, except in that "flag" latch 23-1 is controlled by the RESULT signal. The outputs of flag latches 23-1 to 23-q are applied to the q remaining inputs of AND gate 25. Block 16A thus essentially consists of a bank of registers to store the defective word addresses. When all inputs of AND gate 25 are raised to a logic "1", the output signal, labelled COMPOSITE RESULT (CR), is raised to "1" to indicate that all registers have been filled. In block 16B, said CR signal generated by AND gate 25 is applied to the first input of 2-way OR gate 26 whose output is connected to latch 27. The output of latch 27 is connected to the second input of OR gate 26. This connection forms a self-locking loop, so that when latch 27 is set to a logic "1", its content can no longer be changed. Block 16B thus essentially consists of a self-maintained fail register latch 27. In block 16C, the RESULT signal is applied to the first input of 2-way OR gate 28, whose output is connected to latch 29. OR gate 28 and latch 29 are implemented in a similar way with respect to OR gate 26 and latch 27 of block 16B, as apparent from Fig. 2. Latch 29 is usually referred to as the "fail/ no fail" latch.

Operation of the conventional fail address register unit 16 of Fig. 2 reads as follows. During a READ operation in the ABIST mode, the RESULT signal supplied by the data compression unit 15 and the STADD* signals supplied by ABIST unit 11 are used in order to memorize the defective word line addresses. At each cycle, address load register 21 receives the current word address from the STADD* bus and, at the following cycle, its content is presented in parallel to the input of all fail registers 22-1 to 22-q, but will be copied only in those of said fail address registers, whose flag latches have not been locked. Due to the pipeline organization of the ABIST unit 11, register 21 is used to delay the STADD* signals by one cycle with respect to the RESULT signal. At each fail detected by data compression unit 15, the RESULT signal is raised to the "1" logic level and for the first fail encountered, this information is saved in the "fail/no fail" latch 29. OR gate 28 is used in conjunction with "fail/no fail" latch 29 to save this information during the totality of the ABIST mode, i.e. in either the two mfg and system submodes. Simultaneously, the flag latch pair 23-1 is locked to a logic "1", and this value inhibits its corresponding fail register 22-1, i.e. it prevents any change thereof, by deactivating its LSSD C clock signal. This fault detection process continues under the control of enabler logic 24 until register 22-q is reached. At each cycle, the intermediate results are combined in the AND gate 25 to generate the CR signal. If the number of defective word line addresses found exceeds the number of available redundant word lines (or the fuse repair capabilities), the CR signal is raised to the high level (logic "1"), on the following cycle. This information is saved in latch 27, where it will be maintained during the totality of the ABIST mfg sub-mode (and in the system sub-mode as well, but in this case, the information is not used). When latch 27 is set to a logic "1", the memory unit 12 is considered "unfixable", i.e. the product chip must be rejected. Dedicated latch 27 is usually referred to, in the literature, as the "not fixable" latch.

With the hardware of Figs. 1 and 2, the current test methodology is illustrated by algorithm 30 of Fig. 3. Product chips at the wafer level stocked in box 31 are first tested in box 32, to identify initially good (IG), repairable (r), and bad (B) chips. Bad chips are rejected in box 33. Repairable chips are fixed in box 34 to allow the subsequent use of spare redundant word lines. As explained above by reference to Fig. 2, during the ABIST mfg submode, addresses of defective word lines are identified and stored in the registers of fail address register unit 16. Then, the SCAN mode is performed as standard, the fail address registers 22-1 to 22-q forming the LSSD chain are unloaded and these addresses transferred to the tester. Finally, these defective word addresses are sent from the tester to a conventional fuse tool to be written in storage unit 19 by any conventional laser fuse blow technique. Each defective word address corresponds to a register in fail register unit 16 and a row of fuses in storage unit 19. For each row, an additional "flag" fuse is provided which corresponds to the "flag" latch in fail address register unit 16, which indicates whether the defective word line is active or not. Once these defective word line addresses have been permanently stored in storage unit 19, the repaired chips are tested in box 35 to determine their functionality. Bad chips are rejected in box 33. Repaired good (RG) chips coming from box 35 and initially good (IG) chips coming from box 32, are submitted to the burn-in step in box 36, then tested in box 37. Depending on the results of the post burn-in or final test completed in box 37, only finally good (FG) chips are retained for shipment in box 38, while bad chips are rejected from the production lots in box 33.

With the above described conventional technique, only a one-pass fuse blow is possible in the ABIST mode. A second pass fuse blow would not be possible after final test in box 34 because, had a fail been detected, there would be no means to identify its location of origin: the regular array 12A' or the redundant array 12A''. A defective word line detected by ABIST unit 11 could be possibly located in the redundant array 12A''. As a matter of fact, there is no known means to adequately test redundant array 12A''. An iterative process to repair the product chip is not possible, because if a defective word line that has already been replaced by a redundant word line during the first pass has to be repaired in box 34, two redundant word lines would be mapped on the same word address, which is not acceptable. Even if there are fuses available for replacing this defective word line, the chip cannot be repaired and would be considered to be bad, while it could have been repaired. Another problem encountered is that there is no way to track whether or not, some or all of the redundant addresses have already been used. As a consequence, the ABIST unit 11 may indicate that the memory unit of a product chip is repairable, when in reality, it is not. Presently, chips that fail after a single pass of laser fuse blow are rejected because it is not possible to determine whether or not all redundant lines have been used. In all cases, the manufacturing yields are diminished.

In addition, with the methodology of Fig. 3, there is no means to determine if a chip has already been repaired or not (unless special marking/handling is performed), because initially good and repaired good chips are sorted and stocked in the same way in box 38. It is admitted that in the future, in the ABIST system sub-mode, should a fail appear during the life of the chip while functioning in a system, for instance at a customer location, it will be in situ and automatically repaired using electrical fuses. Electrical fuses are a sort of fuses that can be electrically blown as opposed to conventional fuses that can only be laser blown using a complex laser tool. It could be thus very important in the future to distinguish initially good from repaired good product chips in that regards to allow self-repair during chip life.

All these inconveniences result from the limitation of the prior art technique based on a single pass fuse blow methodology. Consequently, for the reasons given above, it is highly desirable to date, and it will be even more important in the future, that a second pass fuse blow be made possible at the time the chip is manufactured and during its commercial life as well. A second pass fuse blow provides not only a significant improvement in manufacturing yields, but also allows self-repair (by in-situ reconfiguration of electrical fuses) of the chip during its commercial life. It will therefore, also improve the in-field serviceability of the system incorporating such product chips.

Therefore, it is a primary object of the present invention to provide a novel circuit that identifies defective redundant word lines in SRAM macros combining an ABIST structure and a redundancy mechanism, thereby allowing a two-pass fuse blow to improve manufacturing yields.

It is another object of the present invention to provide a novel circuit that identifies defective redundant word lines in SRAM macros combining an ABIST structure and a redundancy mechanism, thereby allowing a two-pass fuse blow that is extendable to an N-pass fuse blow to improve in-field system serviceability.

These objects will be accomplished in particular by an integrated circuit, such as a SRAM macro, which includes a novel circuit according to claim 1.

According to the basic principles of the present invention, there is provided a novel circuit that identifies defective redundant word lines in SRAM macros provided with an ABIST structure and a redundancy mechanism. The novel circuit generates a signal whose logic value indicates whether or not a fail has been detected in a selected word line of the redundant array. To that end, the novel circuit combines existing signals: the selection signals R1 to Rq, the RESULT and the COMPOSITE RESULT signals that are generated in conventional SRAM macros provided with an ABIST structure and a redundancy mechanism. The selection signals R1 to Rq indicate whether or not a redundant word line has been selected. The RESULT signal indicates after a READ operation whether the selected word line of the memory unit at the address being tested is defective or not. The COMPOSITE RESULT signal indicates that the number of fails detected exceeds the number q of redundant word lines. All these signals run on a cycle per cycle basis. The q selection signals R1 to Rq are applied to a q-way OR gate whose output is connected to a latch. The signal which is output by the latch and the RESULT signal are ANDed in an AND gate. The signal which is generated by the AND gate (indicative that the current redundant word line is defective) is available for any further processing. Preferably, this signal and the COMPOSITE RESULT signal are applied as input signals to the first and second inputs of a 3-way OR gate, whose output is connected to the "not fixable" latch. In turn, the output of this latch is connected to the remaining third input of the said 3-way OR gate. If there is a fail on a redundant word line, the "not fixable" latch (which holds the information as to the repairability of the memory unit) is thus set to warn a non repairable state. The "not fixable" latch indicates not only whether there are more fails than the number that can be fixed, but at the same time, whether a fail has been found in the redundant array of the memory unit. As a result, a two-pass fuse blow process (extendable to a N-pass fuse blow) is now made possible. This second pass fuse blow can be performed either in the manufacturing environment, before or after burn-in step, or in the system environment should electrical fuses be available.

The features believed to be characteristic of this invention are set forth in the claims. The invention itself, however, as well as other objects and advantages thereof may be best understood by reference to the following detailed description of an illustrated preferred embodiment to be read in conjunction with the accompanying drawings.

Fig. 1 shows the partial schematic view of the block diagram architecture of a state of the art SRAM macro including an ABIST unit combined with a redundancy mechanism.

Fig. 2 shows schematic details of a conventional circuit implementation of the fail register unit 16 of Fig. 1 which allows only a one-pass fuse blow.

Fig. 3 illustrates the algorithm at the base of the standard one-pass fuse blow methodology used in conjunction with the hardware of Figs. 1 and 2.

Fig. 4 illustrates the novel circuit which allows a two-pass fuse blow to the state of the art SRAM macro of Fig. 1 including an ABIST unit combined with a redundancy mechanism and the modifications to be brought to the fail register unit 16 according to the present invention.

Fig. 5 illustrates the algorithm of the two-pass fuse blow methodology of the present invention that can be used in conjunction with the hardware of Figs. 1 and 4.

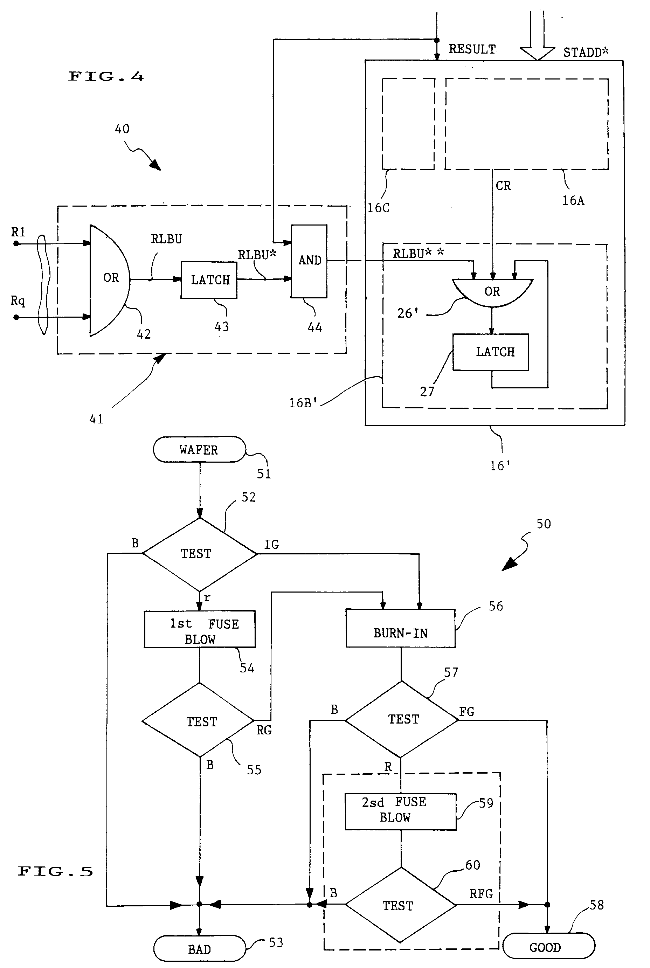

Fig. 4 is a schematic representation of the new implementation referenced 40, which essentially consists of the novel circuit referenced 41 and of unit 16, now labelled 16', after modification thereof. The only difference between unit 16 and unit 16', lies in block 16B' which is derived from block 16B of Fig. 2. Circuit 41 first comprises a q-way OR 42 whose inputs are connected in parallel to the wires transporting the R1 to Rq selection signals. The signal which is output is referred to as the Redundant Line Being Used (RLBU) signal. The latter is applied to a latch 43 to be stored therein. Latch 43 has the key role to synchronize the cycles between the memory unit 12 and the ABIST unit 11. In the 2-way AND gate 44, the RESULT signal is gated with the "delayed" RLBU signal, labelled RLBU*, output by latch 43, to generate in turn, a signal labelled RLBU**. In block 16B', the only change with respect to block 16B lies in 2-way OR gate 26 which now becomes a 3-way OR gate referenced 26', whose additional input is connected to the output of AND gate 44, so that the signals that are applied to the 3-way OR gate 26' are the RLBU**, the CR signal, and the signal which is output of the "not fixable" latch 27. Circuit 41 is therefore an independent circuit added to the architecture of the SRAM macro 10 shown in Fig. 1 which receives the RESULT signal and the R1-Rq selection signals. The RLBU** signal which is output therefrom may be used for any other type of processing.

The RLBU signal is at a high logic level, i.e. at a logic "1" if at least one redundant word line is being activated. In the case when the RESULT signal is at a logic "0", i.e. no fail detected, and the RLBU* signal is at a logic "1", which means one redundant word line was used in a previous cycle, the RLBU** signal remains at a logic "0", this is the normal operation according to the redundancy mechanism. But, in the case when the RESULT and RLBU* signals are simultaneously set at the logic "1", this means one redundant word line was used and was found defective. According to a significant feature of the present invention, and regardless the value of the CR signal, the "not fixable" latch 27 is immediately raised to a logic "1". In this case, the product chip is declared bad and rejected. As apparent from Fig. 4, the RLBU signal is thus propagated thru circuit 41 and combined with the RESULT signal before being applied as an input to the 3-way OR gate 26' to override to "1" the "not fixable" latch 27 content. Therefore, the "not fixable" latch 27 is not only set as described in Ref. D1, but it also is set as soon as a fail is discovered on a redundant word line in the ABIST mode.

With the hardware of fig 4, the new test methodology supporting a two-pass fuse blow is illustrated by algorithm 50 depicted in Fig. 5. Product chips at the wafer level stocked in box 51 are first tested in box 52, to identify initially good (IG), repairable (r), and bad (B) chips. Bad chips are rejected in box 53. Repairable chips are fixed in box 54 to allow the subsequent use of spare redundant word lines, as explained above in the description of Fig. 3. Once the defective word line addresses have been permanently stored in storage unit 19, the repaired chips are tested in box 55 to determine their functionality. Bad chips are rejected in box 53. Repaired good (RG) chips coming from box 55 and initially good (IG) chips coming from box 52 are submitted to the burn-in step in box 56, then, tested in box 57. Depending on the results of the post burn-in test completed in box 57, finally good (FG) chips are retained for shipment in box 58, while bad chips are rejected from the production lots in box 53. According to the present invention, chips found to be repairable (R) after the post burn-in test 57, can now be repaired using a second pass fuse blow in box 59. Next, the final test is performed in box 60. Repaired finally good (RFG) chips are collected in box 58, while bad chips are rejected in box 53. As a result, the number of chips tested as being good and collected in box 58 has been significantly increased with respect to the methodology of Fig. 3.

With the prior art methodology of Fig. 3, the content of the "not fixable" latch 27 is insufficient for determining correctly whether or not a product chip is fixable after the first fuse blow has been performed. On the contrary, according to the present invention, latch 27 content is now sufficient to fully exploit the redundancy mechanism.

For the purpose of simplicity, a two-pass fuse blow has been described, but a N-pass fuse blow could be envisioned as well. It could be therefore possible now to repair a memory unit that has been repaired many times, in either the system or the manufacturing environments. Such a N-pass fuse blow methodology will optimize the redundancy utilization and increase the system serviceability even more.

The present invention may be further improved. A "trace" mechanism can be incorporated indicating whether or not redundant word lines have been used to replace defective word lines. The suggested implementation consists in the inclusion of a dedicated latch per redundant word line, which, when set, indicates that the corresponding redundant word line has been used. This can be obtained by paralleling a latch on each "flag" wire of the DADD bus. A way of implementation would be to use the already existing "flag" fuse mentioned above, and to store this information into a latch attached thereto. The use of the "trace" latches will allow the ABIST unit 11 to use all the existing redundant lines during a N-pass fuse blow methodology and to ensure thereby a complete tracking of the redundant word lines utilization.

The advantages of the present invention are manifold. First of all, it provides a better exploitation of the redundancy mechanism and tracking in the SRAM macro 10. Moreover, it produces a higher degree of confidence that the product chips will work correctly. Finally, the benefits will be seen in manufacturing yields. As soon as electrically blown fuses be introduced in future product chips, the benefits will be also at the system level. These advantages are obtained at a low cost, because a very little overhead is required for the product chips as demonstrated above in connection with the circuit 40 of Fig. 4. Although the present invention has been described by reference to redundant word lines, it is fully applicable to bit line or block redundancy as well.

The present invention may find wide application to the test of large memories of either the RAM (e.g. SRAMs, DRAMs,...) or ROM (including flash memories) type.

## Claims

1. An integrated circuit incorporating at least one macro of the type including:
a memory unit (12) formed by a regular array (12A'), a redundant array (12A'') and a comparator (12C);
a dedicated ABIST unit (11) for the self-test of the memory unit word lines;
a data compression unit (15) that generates a first signal (RESULT) to indicate after a READ operation whether the address of the memory unit word line being tested is defective or not;
a fail register unit (16) consisting of three blocks: a block (16A) to store the defective word addresses, a block (16B) formed by a "not fixable" latch (27) and a 2-way OR gate (26), and a "fail/no fail latch block (16C), to process the said first signal (RESULT) and the word portion of the self-test address signals (STADD*) generated by the ABIST unit to deliver a second signal (COMPOSITE RESULT) that indicates whether the number of defective word lines exceeds the number q of redundant word lines of the redundant array;
wherein said comparator compares the word portion of the word line address being used with the addresses of the defective word lines stored in a storage unit (19) to generate q selection signals (R1 to Rq) to select one among q redundant word lines of the redundant array;
characterized in that it further includes a dedicated circuit (41) comprising:
a q-way OR gate (42), whose each input is connected to one of said selection signals (R1 to Rq) generated by said comparator and whose output is connected to a latch (43); and,
a 2-way AND gate (44) whose first input is connected to the output of said latch (43) and whose second input is driven by the said first signal (RESULT) to generate a signal (RLBU**) which indicates whether the redundant word line that was used is defective or not.

2. The integrated circuit of claim 1 wherein said second (16B) now consists of:
a 3-way OR gate (26') and the "not fixable" latch (27) connected in series, wherein the output of said "not fixable" latch is connected to the first input of said 3-way OR gate, the second input is driven by the COMPOSITE RESULT signal, and the third input is connected to the output of said 2-way AND gate (44).
